# EUROPEAN PATENT APPLICATION

(11) **EP 4 311 383 A2**
(43) Date of publication of application: **24.01.2024**
(21) Application number: 23181316.3
(22) Date of filing: 23.06.2023
(51) Int. Cl.: H05K 7/14, H02J 7/00, H05K 5/06

(54) **POWER SUPPLY INCLUDING INGRESS PROTECTION**

(30) Priority: 28.06.2022 US 202263356099 P; 12.08.2022 US 202263371240 P
(71) Applicant: Milwaukee Electric Tool Corporation, Brookfield, WI 53005 (US)
(72) Inventor: KORBEL, Megan, Wauwatosa (US); KRUTIKOVA, Maria, Wauwatosa (US)
(74) Representative: Forresters IP LLP

(57) **Abstract**

A portable power supply including a housing, a power source, a first subsystem electrically connected to the power source and positioned within the housing, and a second subsystem electrically connected to the power source and positioned within the housing. A plurality of wires electrically connect the power source, the first subsystem, and the second subsystem. The plurality of wires are ingress protected. The first subsystem and the second subsystem are ingress protected when positioned in the housing.

## Description

### CROSS-REFERENCE TO RELATED APPLICATIONS

The application claims priority to and the benefit of U.S. Provisional Application No. 63/356,099, filed June 28, 2022, and U.S. Provisional Application No. 63/371,240, filed August 12, 2022, the disclosures of which are each hereby incorporated by reference herein in their entireties.

### FIELD

The present disclosure relates to portable power supplies, and more specifically to ingress protection for portable power supplies.

### BACKGROUND

Portable power supplies are used to supply power to a variety of tools. The portability of the power supply allows for transportation of the power supply such that the power supply can power tools and devices in different locations.

### SUMMARY

The present disclosure provides, in one aspect, a portable power supply including a housing, a power source, a first subsystem electrically connected to the power source and positioned within the housing, and a second subsystem electrically connected to the power source and positioned within the housing. The plurality of wires electrically connect the power source, the first subsystem, and the second subsystem. The plurality of wires are ingress protected. The first subsystem and the second subsystem are ingress protected when positioned in the housing.

The present disclosure provides, in another aspect, a portable power supply including a housing movable between a static use mode and a transportation mode. A first subsystem is ingress protected and positioned within the housing. A weep hole is positioned at a lower wall of the housing. The lower wall is parallel with a ground surface in the static use mode, and the lower wall is angled relative to the ground surface in the transportation mode. The weep hole weeps in the static use mode and the transportation mode.

The present disclosure provides, in another aspect, a portable power supply including a housing, a first subsystem being ingress protected and positioned within the housing, a second subsystem being ingress protected and positioned within the housing, and a human-machine interface that is detached from the housing. The first subsystem includes a first ingress protection rating, and the second subsystem includes a second ingress protection rating. The first ingress protection rating is different than the second ingress protection rating.

The present disclosure provides, in another aspect, a portable power supply comprising:
a housing;
a power source;
a first subsystem electrically connected to the power source and positioned within the housing;
a second subsystem electrically connected to the power source and positioned within the housing; and
a plurality of wires electrically connecting the power source, the first subsystem, and the second subsystem, the plurality of wires being ingress protected,
wherein the first subsystem and the second subsystem are ingress protected when positioned in the housing.

The portable power supply may include an ingress protection rating, and wherein the ingress protection rating of the portable power supply may remain constant when the first subsystem or the second subsystem is removed from the housing.

The first subsystem may be ingress protected when removed from the housing.

The first subsystem may be only ingress protected when positioned within the housing.

The first subsystem may include a lid and a body, the lid and the body being joined with a gasket, and wherein a grommet may be positioned proximate the gasket to allow wires to pass from within the body to a location external from the body.

The first subsystem may include a gore valve positioned on the body, the gore valve configured to equalize an internal pressure within the body.

The second subsystem may include louvered vents configured to divert water ingress away from the second subsystem.

The housing may be selectively perforated.

The first subsystem and the second subsystem may be sealed against the housing.

The present disclosure provides, in another aspect, a portable power supply comprising:
a housing movable between a static use mode and a transportation mode;
a first subsystem being ingress protected and positioned within the housing; and
a weep hole positioned at a lower wall of the housing,
wherein the lower wall is generally parallel with a ground surface in the static use mode, and the lower wall is angled relative to the ground surface in the transportation mode, and wherein the weep hole weeps in the static use mode and the transportation mode.

The portable power supply may further comprise a second subsystem positioned within the housing and being ingress protected when positioned within the housing.

The first subsystem may include a first ingress protection rating and the second subsystem may include a second ingress protection rating, and wherein the first ingress protection rating may be different than the second ingress protection rating.

A path may be formed between the first subsystem and the second system, the path configured to route debris and/or water to the weep hole.

In the transportation mode, debris and standing water may be prevented from entering the housing through the weep hole.

The present disclosure provides, in another aspect, a portable power supply comprising:
a housing;
a first subsystem being ingress protected and positioned within the housing;
a second subsystem being ingress protected and positioned within the housing; and
a human-machine interface that is detached from the housing,
wherein the first subsystem includes a first ingress protection rating and the second subsystem includes a second ingress protection rating, and wherein the first ingress protection rating is different than the second ingress protection rating.

The portable power supply may include a third ingress protection rating, the third ingress protection rating remaining constant when the first subsystem or the second subsystem is removed from the housing.

The third ingress protection rating may be different than the first ingress protection rating or the second ingress protection rating.

The human-machine interface may communicate with the portable power supply through a Bluetooth connection.

The human-machine interface may include an application software program executable on a smart device.

The first subsystem may be a power source, the human-machine interface configured to communicate with the power source through a wired connection.

Additional features and aspects of the disclosure will become apparent by consideration of the following detailed description and accompanying drawings.

### BRIEF DESCRIPTION OF THE DRAWINGS

FIG. 1 is a perspective view of a portable power supply, according to some implementations of the present disclosure.
FIG. 2 is a cross-sectional side view of the portable power supply of FIG. 1 along Section 2-2, according to some implementations of the present disclosure.
FIG. 3 is a partially exploded perspective view of a power source enclosure of the portable power supply of FIG. 1, according to some implementations of the present disclosure
FIG. 4 is a perspective cross-sectional view of a grommet for the power source enclosure of FIG. 3, according to some implementations of the present disclosure.
FIG. 5 is a partial perspective view of one or more grommets and a gasket disposed below a detachable window lid of the power source enclosure of FIG. 3, according to some implementations of the present disclosure.
FIG. 6 is a partially exploded perspective view of a charger of the portable power supply of FIG. 1, according to some implementations of the present disclosure.
FIG. 7 is a partial perspective cross-sectional view of the portable power supply of FIG. 1 along a portion of Section 7-7, according to some implementations of the present disclosure.
FIG. 8 is a perspective view of a portable power supply, according to some implementations of the present disclosure.
FIG. 9 is a partial perspective view of an inverter of the portable power supply of FIG. 1, according to some implementations of the present disclosure.
FIG. 10 is a cross-sectional side view of the portable power supply of FIG. 1 along Section 2-2 further depicting channels, according to some implementations of the present disclosure.
FIG. 11 is a partial cross-sectional side view of the portable power supply of FIG. 10 when a housing is in a static use mode, according to some implementations of the present disclosure.
FIG. 12 is a partial cross-sectional side view of the portable power supply of FIG. 10 when a housing is in a transportation mode, according to some implementations of the present disclosure.

Before any embodiments of the disclosure are explained in detail, it is to be understood that the invention is not limited in its application to the details of construction and the arrangement of components set forth in the following description or illustrated in the referenced drawings. The invention is capable of other embodiments and of being practiced or of being carried out in various ways. Also, it is to be understood that the phraseology and terminology used herein is for the purpose of description and should not be regarded as limiting.

### DETAILED DESCRIPTION

Features illustrated or described as part of one embodiment can be used with another embodiment to yield a still further embodiment. Thus, it is intended that the present disclosure covers such modifications and variations as come within the scope of the appended claims and their equivalents. The detailed description uses numerical and letter designations to refer to features in the drawings. Like or similar designations in the drawings and description have been used to refer to like or similar parts of the disclosure.

As used herein, the terms "first", "second", and "third" may be used interchangeably to distinguish one component from another and are not intended to signify location or importance of the individual components. The singular forms "a," "an," and "the" include plural references unless the context clearly dictates otherwise. The terms "coupled," "fixed," "attached to," and the like refer to both direct coupling, fixing, or attaching, as well as indirect coupling, fixing, or attaching through one or more intermediate components or features, unless otherwise specified herein. As used herein, the terms "comprises," "comprising," "includes," "including," "has," "having" or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive "or" and not to an exclusive " or". For example, a condition A or B is satisfied by any one of the following: A is true (or present) and B is false (or not present), A is false (or not present) and B is true (or present), and both A and B are true (or present).

Terms of approximation, such as "generally," "approximately," or "substantially," include values within ten percent greater or less than the stated value. When used in the context of an angle or direction, such terms include within ten degrees greater or less than the stated angle or direction. For example, "generally vertical" includes directions within ten degrees of vertical in any direction, e.g., clockwise or counterclockwise.

Benefits, other advantages, and solutions to problems are described below with regard to specific embodiments. However, the benefits, advantages, solutions to problems, and any feature(s) that may cause any benefit, advantage, or solution to occur or become more pronounced are not to be construed as a critical, required, or essential feature of any or all the appended claims.

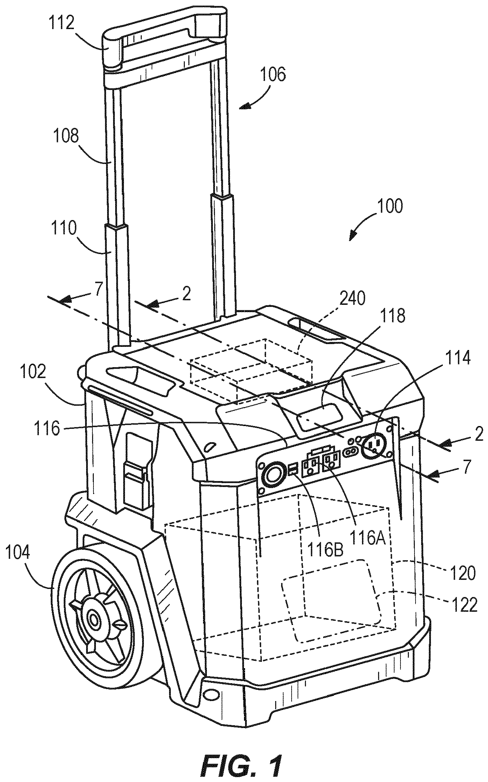

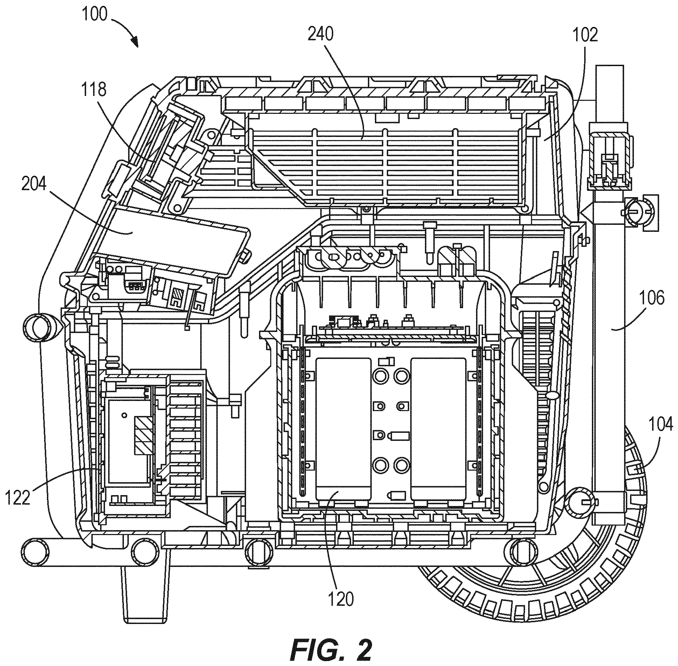

Turning now to FIGS. 1 and 2, a portable power supply device or power supply 100 is depicted. The depicted power supply 100 is configured to be ingress protected. Ingress protection refers to a sealing protection of an electronic component against an intrusion of solids and/or liquids using a sealed enclosure for the component. For example, in an environment where dust or water could damage electronic components, a sealed enclosure is used to prevent ingress. Enclosures that are ingress protected additionally have an ingress protection rating, or an IP rating. The power supply 100 includes an IP rating. In other words, the entire power supply 100 system has an overall IP rating. Additionally, subsystems within the power supply 100 each have an individual IP rating, as explained below. However, failure of a subsystem does not alter or change the IP rating of the power supply 100. For example, if the power supply 100 IP rating is IP66, the power supply 100 IP rating of IP66 would not decrease to a lower rating if a subsystem begins to fail, or leak. Therefore, the failure of the IP of a subsystem is contained to solely that subsystem. IP ratings as used herein can be defined by international standards, such as International Electrotechnical Commission 60529, which classifies and provides a guideline to the degree of protection provided by mechanical casings and electrical enclosures against the intrusion of dust, accidental contact, and water. IP ratings are not necessarily linear. For example, a component may be IPX7 rated, however, the component may fail the IPX6 rating test. Failing the IPX6 rating test does not impact the IPX7 rating. In other words, each ingress protection rating includes individual and distinct test(s).

The power supply 100 includes, among other things, a housing 102. In some embodiments, the housing 102 includes one or more wheels 104 and a handle assembly 106. In the illustrated embodiment, the handle assembly 106 is a telescoping handle movable between an extended position and a collapsed position. The handle assembly 106 includes an inner tube 108 and an outer tube 110. The inner tube 108 fits inside the outer tube 110 and is slidable relative to the outer tube 110. The inner tube 108 is coupled to a horizontal holding member 112. In some embodiments, the handle assembly 106 further includes a locking mechanism to prevent inner tube 108 from unintentionally moving relative to the outer tube 110. The locking mechanism may include notches, sliding catch pins, or another suitable locking mechanism to inhibit the inner tube 108 from sliding relative to the outer tube 110 when the handle assembly 106 is in the extended position and/or in the collapsed position. In practice, a user holds the horizontal holding member 112 and pulls upward to extend the handle assembly 106. The inner tube 108 slides relative to the outer tube 110 until the handle assembly 106 locks in the extended position. The user may then pull and direct the power supply 100 by the handle assembly 106 to a desired location. The wheels 104 of the power supply 100 facilitate such movement. In some embodiments, the housing 102 additionally includes perforation(s) along select components of the housing 102. In other embodiments, the housing 102 may not include perforation(s).

The housing 102 of the power supply 100 further includes a power input unit 114, a power output unit 116, and a display 118. In the illustrated embodiment, the power input unit 114 includes multiple electrical connection interfaces configured to receive power from an external power source. In some embodiments, the external power source is a DC power source. For example, the DC power source may be one or more photovoltaic cells (e.g., a solar panel), an electric vehicle (EV) charging station, or any other DC power source. In some embodiments, the external power source is an AC power source. For example, the AC power source may be a conventional wall outlet, such as a 120 V outlet or a 240 V outlet, found in North America. As another example, the AC power source may be a conventional wall outlet, such as a 220V outlet or 230V outlet, found outside of North America. In some embodiments, the power input unit 114 is replaced by or additionally includes a cable configured to plug into a conventional wall outlet. In some embodiments, the power input unit 114 further includes one or more devices, such as antennas or induction coils, configured to wirelessly receive power from an external power source. The power received by the power input unit 114 may be used to charge a core battery, or internal power source 120, disposed within the housing 102 of power supply 100. The power input unit 114 charges the internal power source 120 via a charger 122 located within the housing 102.

The power received by the power input unit 114 may also be used to provide power to one or more devices connected to the power output unit 116. The power output unit 116 includes one more power outlets. In the illustrated embodiment, the power output unit 116 includes a plurality of AC power outlets 116A and DC power outlets 116B. It should be understood that number of power outlets included in the power output unit 116 is not limited to the power outlets illustrated in FIG. 1. For example, in some embodiments of the power supply 100, the power output unit 116 may include more or fewer power outlets than the power outlets included in the illustrated embodiment of power supply 100.

In some embodiments, the power output unit 116 is configured to provide power output by the internal power source 120 to one or more peripheral devices. The power output unit 116 is also configured to provide power output by the internal power source 120. In some embodiments, the power output unit 116 is configured to provide power provided by an external power source directly to one or more peripheral devices. The one or more peripheral devices may be a smartphone, a tablet computer, a laptop computer, a portable music player, a power tool, a power tool battery pack, a power tool battery pack charger, or the like. The peripheral devices may be configured to receive DC and/or AC power from the power output unit 116.

In some embodiments, the DC power outlets 116B include one or more receptacles for receiving and charging power tool battery packs. In such embodiments, power tool battery packs received by, or connected to, the DC power outlets 116B are charged with power output by the internal power source 120 and/or power received directly from the external power source. In some embodiments, power tool battery packs connected to the DC power outlets 116B are used to provide power to the internal power source 120 and/or one or more peripheral devices connected to outlets of the power output unit 116. In some embodiments, the power output unit 116 includes tool-specific power outlets. For example, the power output unit may include a DC power outlet used for powering a welding tool.

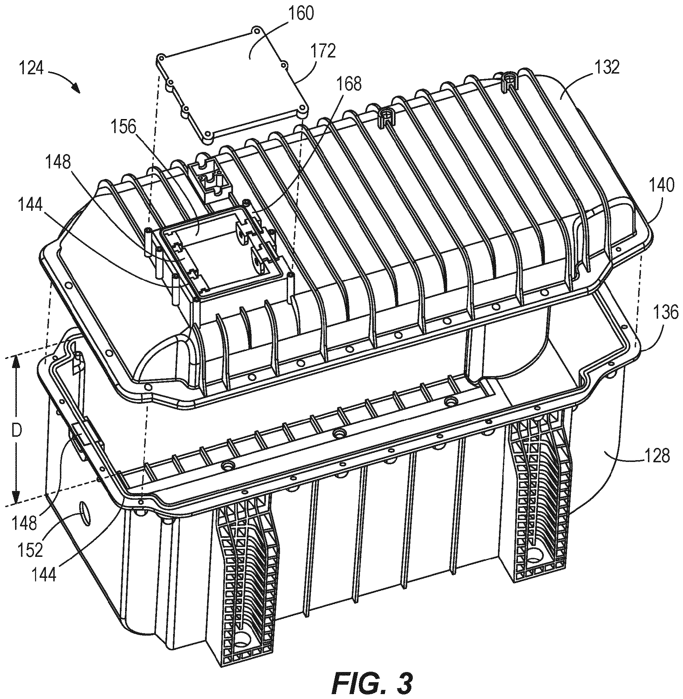

With reference to FIG. 3, the internal power source 120 may be disposed in a power source enclosure 124 and acts as a first subsystem of the power supply 100. The power source enclosure 124 includes a body 128 having a depth, D, and a lid 132, with the lid 132 being separable from the body 128. When the lid 132 is in contact with the body 128, the body 128 and the lid 132 are in contact along a body edge 136 and a lid edge 140, respectively. The power source enclosure 124 additionally includes a gasket 144 and a grommet 148 disposed between the body edge 136 and the lid edge 140. The gasket 144 follows an outline of the body edge 136 and is configured to seal the lid edge 140 to the body edge 136 when the lid 132 is disposed on the body 128. The grommet 148 allows wires to pass through a wall of the body 128 when the body 128 and the lid 132 are sealed via the gasket 144. The grommet 148 additionally facilitates in sealing the lid 132 to the body 128. In some embodiments, the power source enclosure 124 may include multiple grommets disposed between the body edge 136 and the lid edge 140. In other embodiments, the power source enclosure 124 may include solely one grommet disposed between the body edge 136 and the lid edge 140.

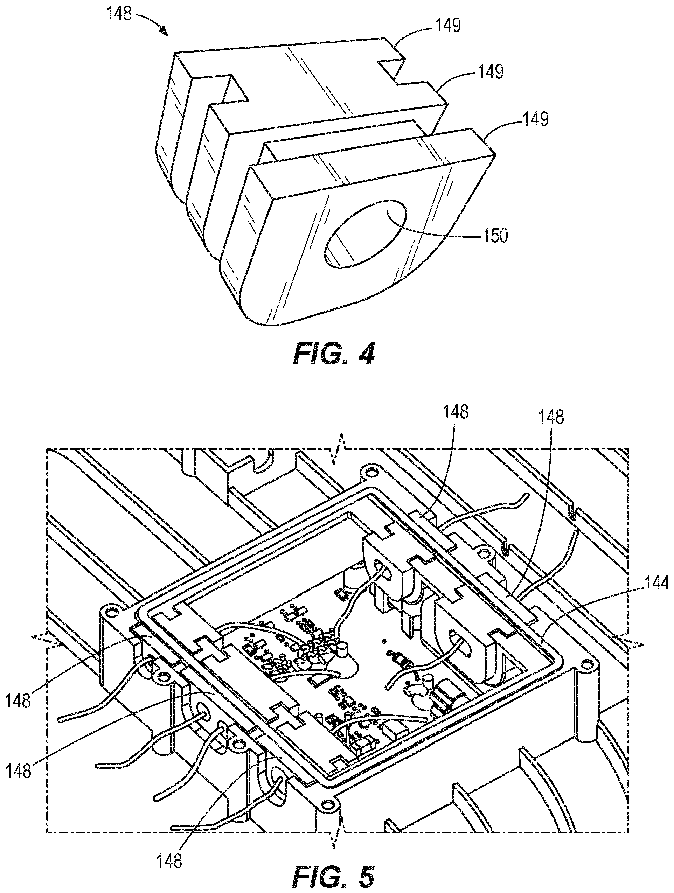

The grommet 148 is shown in FIG. 4. The grommet 148 includes ridges 149 and a center hole 150. The wire (not shown) is disposed in the center hole 150. The ridges 149 provide a counteracting force to stop the grommet 148 from being dislocated from the body edge 136. The ridges 149 additionally direct any non-desirable liquid to pass through multiple dips prior to entering the power source enclosure 124. Therefore, liquid intrusion into the power source enclosure 124 through the grommet 148 is minimized or prevented. The gasket 144 and the grommet(s) 148 are shown in FIG. 5. Including both the gasket 144 and the grommet(s) 148 on the body edge 136 facilitates greater ingress protection of the power source enclosure 124 than a typical enclosure.

The body 128 can include a gore valve 152 (FIG. 3) disposed in a wall of the body 128. When the body 128 and the lid 132 are sealed via the gasket 144 and the grommet 148, the gore valve 152 provides pressure equalization. For example, the gore valve 152 allows air to flow freely in and out of the power source enclosure 124, equalizing a pressure within the power source enclosure 124 and a pressure outside of the power source enclosure 124. The gore valve 152 is additionally configured to block liquids, dust, and contaminants from entering the power source enclosure 124 through the gore valve 152.

The lid 132 includes a window 156 having a detachable window lid 160. The lid 132 further includes the gasket 144 and the grommet(s) 148 disposed between an edge 168 of the window 156 and an edge 172 of the window lid 160. The gasket 144 and grommet(s) 148 disposed between the window 156 and the window lid 160 seal the window lid 160 to the window 156. The grommet(s) 148 allow wires to pass through a surface of the lid 132 while sealing the window lid 160 to the window 156. In some embodiments, the lid 132 may include multiple grommets disposed between the window 156 and the window lid 160. In other embodiments, the lid 132 may include solely one grommet disposed between the window 156 and the window lid 160.

In response to the power source enclosure 124 being sealed when operably assembled, the power source enclosure 124 is ingress protected. Ingress protection refers to protection of electronic(s) against solids and liquids by an electrical enclosure. The power source enclosure 124 includes an ingress protection rating, or IP rating, of IP 67. IP 67 means that ingress of water in harmful quantities is not permitted to enter the enclosure when the enclosure is immersed in water under defined conditions of pressure and time. Additionally, IP67 means that the enclosure is dust-tight such that no dust enters the enclosure. In some embodiments, the IP rating of the power source enclosure 124 may be less than IP67. In other embodiments, the IP rating of the power source enclosure 124 may be greater than IP67. In yet other embodiments, the charger enclosure may have an IP rating that is within the range of IP44 to IP69k (e.g., IP44, IP45, IP46, IP47, IP48, IP49k, IP54, IP55, IP56, IP57, IP58, IP59k, IP64, IP65, IP66, IP67, IP68, IP69k). In some aspects, it is contemplated that the IP ratings of the charger are with respect to the electronic board with in the charger enclosure 176 and not for the entire charger subsystem. The power source enclosure 124 is ingress protected individually. In other words, the power source enclosure 124 is ingress protected whether the power source enclosure 124 is mounted within the power supply 100 or is separate from the power supply 100. In some embodiments, a portion of the power source enclosure 124 may be removed such that the power source enclosure 124 is solely ingress protected when the power source enclosure 124 is mounted in the power supply 100. For example, the lid 132 of the power source enclosure 124 may be removed such that the body of the power source enclosure 124 seals to a surface of the housing.

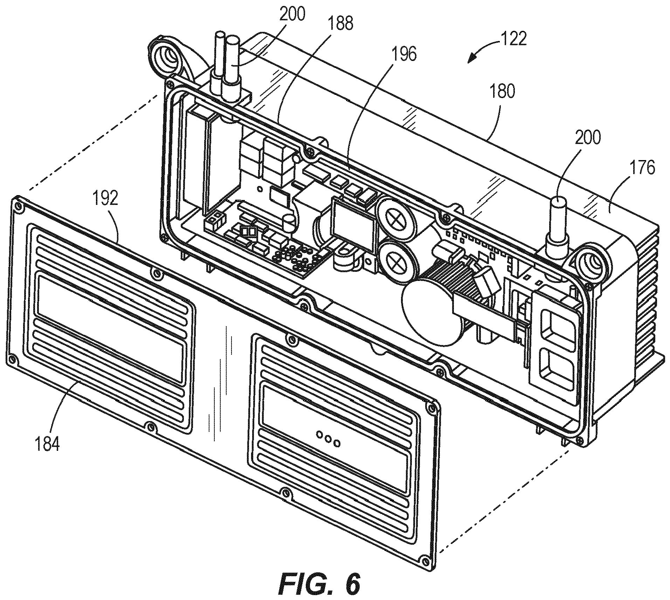

Referring to FIG. 6, the charger 122 is disposed in a charger enclosure 176 and acts as a second subsystem of the power supply 100. The charger enclosure 176 is operationally similar to the power source enclosure 124, described above. The charger enclosure 176 includes a body 180 and a lid 184. When the lid 184 is in contact with the body 180, the body 180 and the lid 184 are in contact along a body edge 188 and a lid edge 192, respectively. The charger enclosure 176 additionally includes a gasket 196 and grommet(s) 200 disposed between the body edge 188 and the lid edge 192. The gasket 196 follows an outline of the body edge 188 and is configured to seal the lid edge 192 to the body edge 188 when the lid 184 is disposed on the body 180. The grommet(s) 200 allows wires to pass through a wall of the body 180 when the body 180 and the lid 184 are sealed via the gasket 196. The grommet(s) 200 additionally facilitates in sealing the lid 184 to the body 180. In some embodiments, the charger enclosure 176 may include multiple grommets disposed between the body edge 188 and the lid edge 192. In other embodiments, the charger enclosure 176 may include solely one grommet disposed between the body edge 188 and the lid edge 192.

Due the charger enclosure 176 being sealed when operably assembled, the charger enclosure 176 is ingress protected. The charger enclosure 176 includes an IP rating of IP66. IP 66 means that water projected in powerful jets from any direction will not have harmful effects electronics held within the enclosure. IP66 additionally means that the enclosure is dust-tight such that no dust enters the enclosure. In some embodiments, the IP rating of the charger enclosure 176 may be less than IP66. In other embodiments, the IP rating of the charger enclosure 176 may be greater than IP66. In yet other embodiments, the charger enclosure may have an IP rating that is within the range of IP44 to IP66 (e.g., IP44, IP45, IP46, IP54, IP55, IP56, IP64, IP65, IP66). In some aspects, it is contemplated that the IP ratings of the charger are with respect to the electronic board with in the charger enclosure 176 and not for the entire charger subsystem. The charger enclosure 176 may be ingress protected individually. In other words, the charger enclosure 176 is ingress protected whether the charger enclosure 176 is mounted within the power supply 100 or is separate from the power supply 100. In some aspects, a portion of the charger enclosure 176 may be removed such that the charger enclosure 176 is solely ingress protected when the charger enclosure 176 is mounted in the power supply 100. For example, the lid of the charger enclosure 176 may be removed such that the body of the charger enclosure 176 seals to a surface of the housing.

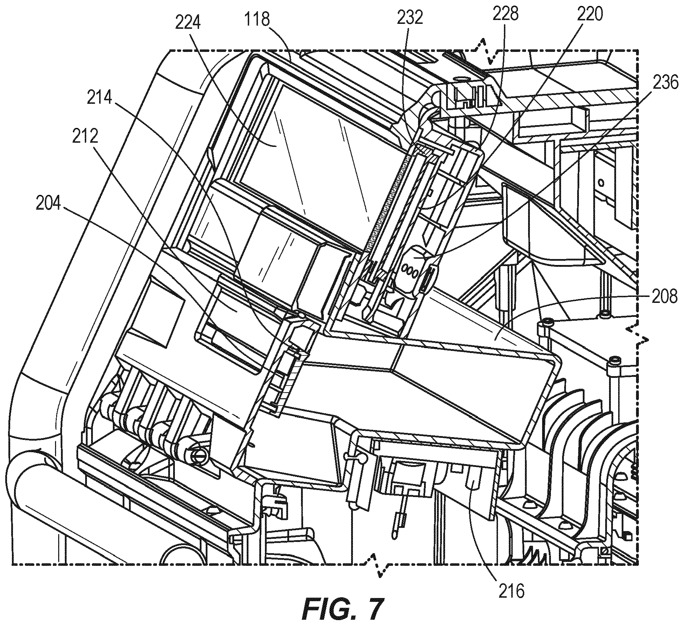

Referring now to FIG. 7, in some embodiments, the DC power outlets may additionally include USB connectors 204, outlets, or the like that act as a third subsystem of the power supply 100. The USB connectors 204 are housed in a compartment 208 positioned proximate the display 118. The compartment 208 includes a door 212 that pivots about a pivot axis. The door 212 includes a latch configured to hold the door 212 in a closed position when the latch is in a latched position. The latch is movable to an unlatched position where the door 212 is movable to an open position. The latch includes a gasket 214 configured to prevent liquid and debris from entering the compartment 208 through the latch when the latch is in the latched position. In some embodiments, the door 212 may include additional gaskets to provide further ingress protection. The USB connectors 204 include a USB board 216. The USB board 216 may be potted and coated such that liquid and debris are prevented from coming into contact with electronics on the USB board 216. The USB board 216 additionally is oriented such that liquid and debris is diverted away from the USB board 216.

As a result of the depicted assembly of the gasket 214 on the door 212 and the coating and potting of the USB board 216, the USB connectors 204 include an IP rating of IP64. IP64 means that ingress of water in harmful quantities is not permitted to enter the enclosure when the enclosure is immersed in water under defined conditions of pressure and time. Additionally, IP64 means that the enclosure is dust-tight such that no dust enters. In some embodiments, the IP rating of the USB connectors 204 may be less than IP64. In other embodiments, the IP rating of the USB connectors 204 may be greater than IP64. In yet other embodiments, the USB connectors may have an IP rating that is within the range of IP32 to IP66 (e.g., IP32, IP33, IP34, IP35, IP36, IP42, IP43, IP44, IP45, IP46, IP52, IP53, IP54, IP55, IP56, IP62, IP63, IP64, IP65, IP66). The USB connectors 204 are ingress protected when disposed in the compartment 208. In other words, the USB connectors 204 are ingress protected solely when the USB connectors 204 are disposed in the power supply 100. In some embodiments, the USB connectors 204 may be individually ingress protected such that the USB connectors 204 are ingress protected when disposed outside of the power supply 100.

With continued reference to FIG. 7, the display 118 is configured to indicate a state of the power supply 100 to a user, such as state of charge of the internal power source 120 and/or fault conditions. The display acts as a fourth subsystem of the power supply 100 and as a human-machine interface. For example, the display 118 can include a button or switch configured to turn on the power unit, turn off the power unit, and similar operations. In some aspects, the display 118 includes one or more light-emitting diode ("LED") indicators configured to illuminate and display a current state of charge of internal power source 120. The display 118 includes a board 220, a screen 224, and a display housing 228. The board 220 controls operation of the display 118. In some embodiments, the board 220 is, for example, a liquid crystal display ("LCD") board, a light-emitting diode ("LED") display board, an organic LED ("OLED") display board, an electroluminescent display ("ELD") board, a surface-conduction electron-emitter display ("SED") board, a field emission display ("FED") board, a thin-film transistor ("TFT") LCD board, etc. The screen 224 is coupled to the display housing 228 such that a space is formed between the screen 224 and a surface of the display housing 228. The board 220 is disposed in the space between the screen 224 and the display housing 228.

In some embodiments, the display 118 is directly coupled to the housing 102 such that the display 118 is visible to the user. The screen 224 of the display 118 interacts with a surface of the housing 102. The screen 224 is enclosed in a gasket 232 such that the spaces between the screen 224, the display housing 228, and the housing 102 are sealed. The board 220 of the display 118 may be encapsulated in a coating, such as a coating that prevents liquid and debris from interfering with electronics on the board. In some embodiments, the board 220 may be coated in an alternative coating. In other embodiments, the board 220 may not be coated. The display housing 228 additionally includes grommet(s) 236 disposed at a bottom surface of the display housing 228. The grommet(s) 236 allow wires to pass through the bottom surface of the display housing 228. The grommet(s) 236 additionally provide sealing for the display housing 228 such that liquid and debris are prevented from entering the display housing 228 through the grommet(s) 236. In some embodiments, the display housing 228 may include multiple grommets. In other embodiments, the display housing 228 may include solely one grommet disposed between the body edge 136 and the lid edge 140.

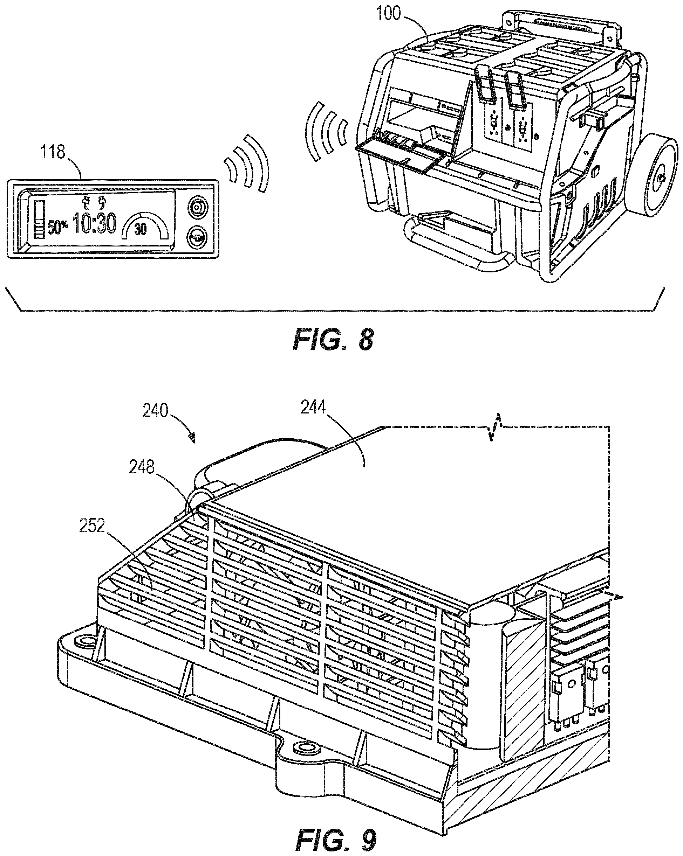

As shown in FIG. 8, in other embodiments, the display 118 may be detached from the housing 102. For example, the internal power source 120 (see FIGS. 1 to 3) may remotely communicate with the display 118 through a cord, a Bluetooth connection, or the like. In some embodiments, the human-machine interface includes an application software program, or app, executable on a smart device. For example, the app may be accessible through a cellular device, a tablet, a computer, or a similar electronic device. To access the app, the user downloads or executes the app and connects to the power supply 100 via the Bluetooth connection or the cord. Once connected, the human-machine interface is visible on the app. The user may power on and off the internal power source 120 by pushing a representation of a button displayed on the smart device. In other embodiments, the human-machine interface may be remotely accessible through a website link, or a similar program.

Referring to FIG. 9, the power supply 100 additionally includes an inverter 240 configured to convert low-voltage DC power from the power input unit to AC power. The inverter 240 acts as a fifth subsystem of the power supply 100 and includes an inverter enclosure 244 which houses an inverter board. The inverter enclosure 244 includes parallel side panels 248. The parallel side panels 248 are perforated such that air is permitted to flow through the parallel side panels. The parallel side panels 248 include louvered vents 252 configured to divert liquid and debris away from the inverter enclosure 244. The inverter board is potted such that liquid and debris is prevented from interacting with electronics on the inverter board. In some aspects, the inverter board may be coated such that liquid and debris are prevented from interacting with the electronics on the inverter board. In other aspects, the inverter board may not include a coating or potting.

As a result of the louvered vents 252, the inverter enclosure 244, and the potting of the inverter board being in an assembled condition, the inverter 240 includes an IP rating of IP66. In some embodiments, the IP rating of the inverter 240 may be less than IP66. In other embodiments, the IP rating of the inverter 240 may be greater than IP66. In other words, the inverter 240 is ingress protected whether the inverter 240 is mounted within the power supply 100 or is separate from the power supply 100. In some aspecs, a portion of the inverter enclosure 244 may be removed such that the inverter 240 is solely ingress protected when the inverter 240 is mounted in the power supply 100. In some aspects, the inverter 240 may have an IP rating that is within the range of IP32 to IP66 (e.g., IP32, IP33, IP34, IP35, IP36, IP42, IP43, IP44, IP45, IP46, IP52, IP53, IP54, IP55, IP56, IP62, IP63, IP64, IP65, IP66). In some aspects, it is contemplated that the IP ratings of the inverter 240 are with respect to the electronic board within the potting or coating and not for the entire inverter subsystem.

The subsystems of the power supply 100 are electrically connected via a series of wires. In some implementations, a first subsystem positioned with the housing 102 may be electrically connected to a power source 120 of the power supply 100 using a daisy-chain type connection through a second subsystem positioned in the housing 102 where the second subsystem is directly connected to the power source 120. In some aspects, the wires may be encapsulated in a heat shrink tube such that the wires are ingress protected. Additionally, any cables or wires that connect the power supply 100 to the external power source are encapsulated in a heat shrink tube such that the cables or wires are ingress protected. Due to the heat shrink, the wires have an IP rating that ranges from IP54 to IP68. In other aspects, an IP rating may be obtained for the wires without the use of heat shrink tubing, such as through the use of IP rated connectors. In yet other aspects, connectors for wire may be ingress protected through the use of dielectric grease or other methods.

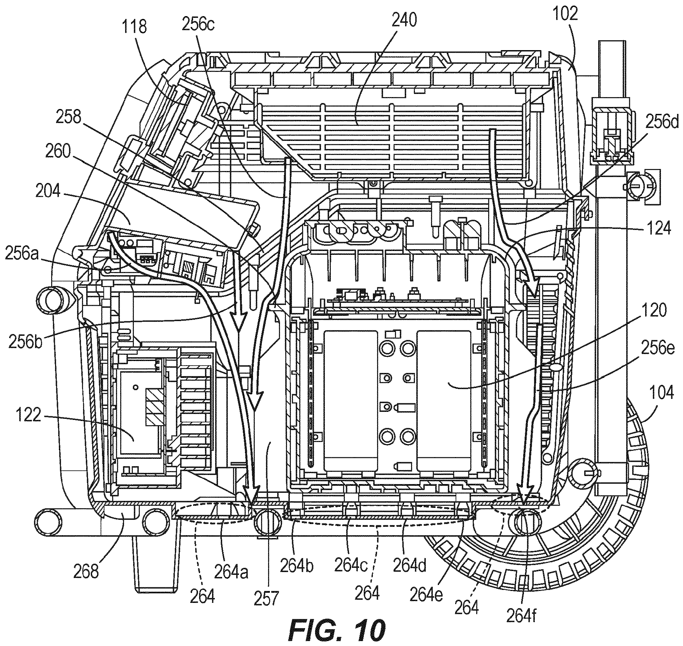

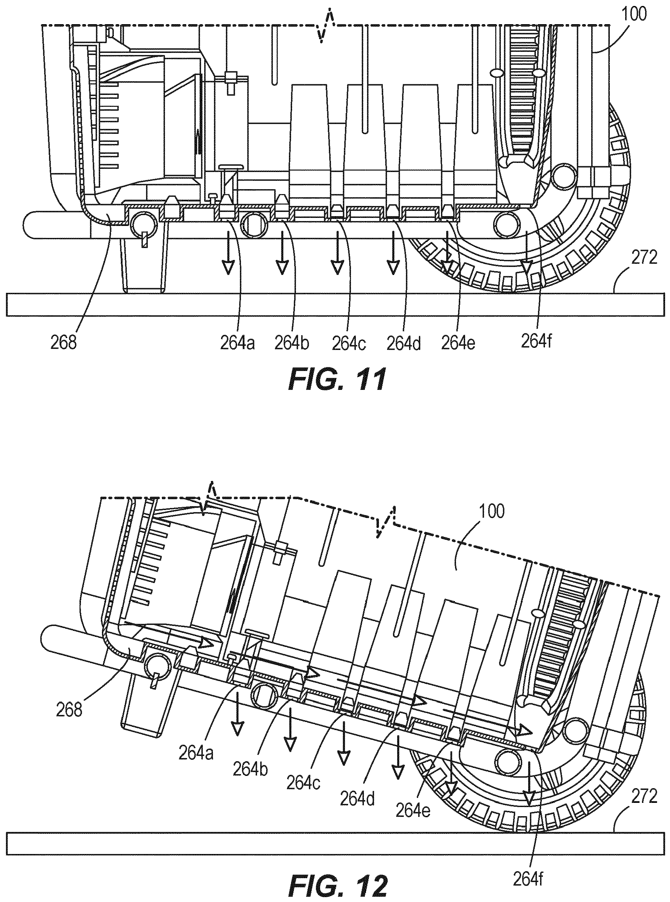

Referring to FIGS. 10 to 12, the subsystems are arranged within the power supply 100 such that one or more channels, such as channels 256a-256e, are formed between the subsystems. For example, the channel 256c may be formed around the power source enclosure 124 such that the power source enclosure 124 is positioned on a first side 257 of the channel 256c and the charger 122, the USB connectors 204, the inverter 240, and the housing 102 are positioned on a second side 258 of the channel 256c that is opposite the first side 257. The channel 256c routes the liquid and debris over a lip 260 of the power source enclosure 124 such that the liquid and debris does not interact with the gasket 144 of the power source enclosure 124. The channel(s) 256a-256e route liquid and debris to weep holes 264 such that liquid and debris, or ingress, does not accumulate within the power supply 100. The weep holes 264 are positioned in a lower wall 268 (shown in FIG. 11) of the housing 102. Liquid and debris exits the weep holes 264, such as weep holes 264a-264f, when the housing 102 is in a static use mode (shown in FIG. 11) and a transportation mode (shown in FIG. 12). In the static use mode, the lower wall 268 is parallel with a ground surface 272. In other words, in the static use mode, an angle between the ground surface 272 and the lower wall 268 is between -10 degrees and 10 degrees. In the transportation mode, the lower wall 268 is angled (shown in FIG. 12) relative to the ground surface 272 such that an angle between the ground surface 272 and the lower wall 268 is greater than 10 degrees or less than -10 degrees. In other words, in the transportation mode, the housing 102 is titled such that the wheel 104 facilitates movement of the power supply 100. The weep holes 264 allow liquid and/or debris to exit the housing 102 in both the static and transportation modes.

In some aspects, the power supply may include more than or less than five subsystems. For example, a power supply can include three subsystems, four subsystems, five subsystems, six subsystem, or seven subsystems. In some aspects, the arrangement of subsystems may be different than the arrangement described above.

Thus, aspects described herein provide, among other things, a power supply including multiple subsystems that are ingress protected. Various features and advantages are set forth in the following claims. When used in this specification and claims, the terms "comprises" and "comprising" and variations thereof mean that the specified features, steps or integers are included. The terms are not to be interpreted to exclude the presence of other features, steps or components.

### REPRESENTATIVE FEATURES

Representative features are set out in the following clauses, which stand alone or may be combined, in any combination, with one or more features disclosed in the text and/or drawings of the specification.
1. A portable power supply comprising:
   a housing;
   a power source;
   a first subsystem electrically connected to the power source and positioned within the housing;
   a second subsystem electrically connected to the power source and positioned within the housing; and
   a plurality of wires electrically connecting the power source, the first subsystem, and the second subsystem, the plurality of wires being ingress protected,
   wherein the first subsystem and the second subsystem are ingress protected when positioned in the housing.
2. The portable power supply of clause 1, wherein the portable power supply includes an ingress protection rating, and wherein the ingress protection rating of the portable power supply remains constant when the first subsystem or the second subsystem is removed from the housing.
3. The portable power supply of clause 1, wherein the first subsystem is ingress protected when removed from the housing.
4. The portable power supply of clause 1, wherein the first subsystem is only ingress protected when positioned within the housing.
5. The portable power supply of clause 1, wherein the first subsystem includes a lid and a body, the lid and the body being joined with a gasket, and wherein a grommet is positioned proximate the gasket to allow wires to pass from within the body to a location external from the body.
6. The portable power supply of clause 5, wherein the first subsystem includes a gore valve positioned on the body, the gore valve configured to equalize an internal pressure within the body.
7. The portable power supply of clause 6, wherein the second subsystem includes louvered vents configured to divert water ingress away from the second subsystem.
8. The portable power supply of clause 1, wherein the housing is selectively perforated.
9. The portable power supply of clause 8, wherein the first subsystem and the second subsystem are sealed against the housing.
10. A portable power supply comprising:
   a housing movable between a static use mode and a transportation mode;
   a first subsystem being ingress protected and positioned within the housing; and
   a weep hole positioned at a lower wall of the housing,
   wherein the lower wall is generally parallel with a ground surface in the static use mode, and the lower wall is angled relative to the ground surface in the transportation mode, and wherein the weep hole weeps in the static use mode and the transportation mode.
11. The portable power supply of clause 10, further comprising a second subsystem positioned within the housing and being ingress protected when positioned within the housing.
12. The portable power supply of clause 11, wherein the first subsystem includes a first ingress protection rating and the second subsystem includes a second ingress protection rating, and wherein the first ingress protection rating is different than the second ingress protection rating.
13. The portable power supply of clause 11, wherein a path is formed between the first subsystem and the second system, the path configured to route debris and/or water to the weep hole.
14. The portable power supply of clause 10, wherein in the transportation mode, debris and standing water are prevented from entering the housing through the weep hole.
15. A portable power supply comprising:
   a housing;
   a first subsystem being ingress protected and positioned within the housing;
   a second subsystem being ingress protected and positioned within the housing; and
   a human-machine interface that is detached from the housing,
   wherein the first subsystem includes a first ingress protection rating and the second subsystem includes a second ingress protection rating, and wherein the first ingress protection rating is different than the second ingress protection rating.
16. The portable power supply of clause 15, wherein the portable power supply includes a third ingress protection rating, the third ingress protection rating remaining constant when the first subsystem or the second subsystem is removed from the housing.
17. The portable power supply of clause 16, wherein the third ingress protection rating is different than the first ingress protection rating or the second ingress protection rating.
18. The portable power supply of clause 15, wherein the human-machine interface communicates with the portable power supply through a Bluetooth connection.
19. The portable power supply of clause 18, wherein the human-machine interface includes an application software program executable on a smart device.
20. The portable power supply of clause 15, wherein the first subsystem is a power source, the human-machine interface configured to communicate with the power source through a wired connection.

## Claims

1. A portable power supply comprising:
a housing;
a power source;
a first subsystem electrically connected to the power source and positioned within the housing;
a second subsystem electrically connected to the power source and positioned within the housing; and
a plurality of wires electrically connecting the power source, the first subsystem, and the second subsystem, the plurality of wires being ingress protected,
wherein the first subsystem and the second subsystem are ingress protected when positioned in the housing.

2. The portable power supply of claim 1, wherein the portable power supply includes an ingress protection rating, and wherein the ingress protection rating of the portable power supply remains constant when the first subsystem or the second subsystem is removed from the housing.

3. The portable power supply of claim 1 or 2, wherein the first subsystem is ingress protected when removed from the housing, or wherein the first subsystem is only ingress protected when positioned within the housing.

4. The portable power supply of any preceding claim, wherein the first subsystem includes a lid and a body, the lid and the body being joined with a gasket, and wherein a grommet is positioned proximate the gasket to allow wires to pass from within the body to a location external from the body, preferably wherein the first subsystem includes a gore valve positioned on the body, the gore valve configured to equalize an internal pressure within the body.

5. The portable power supply of any preceding claim, wherein the second subsystem includes louvered vents configured to divert water ingress away from the second subsystem.

6. The portable power supply of any preceding claim, wherein the housing is selectively perforated and/or wherein the first subsystem and the second subsystem are sealed against the housing.

7. A portable power supply comprising:
a housing movable between a static use mode and a transportation mode;
a first subsystem being ingress protected and positioned within the housing; and
a weep hole positioned at a lower wall of the housing,
wherein the lower wall is generally parallel with a ground surface in the static use mode, and the lower wall is angled relative to the ground surface in the transportation mode, and wherein the weep hole weeps in the static use mode and the transportation mode.

8. The portable power supply of claim 7, further comprising a second subsystem positioned within the housing and being ingress protected when positioned within the housing.

9. The portable power supply of claim 8, wherein the first subsystem includes a first ingress protection rating and the second subsystem includes a second ingress protection rating, and wherein the first ingress protection rating is different than the second ingress protection rating.

10. The portable power supply of claim 9, wherein a path is formed between the first subsystem and the second system, the path configured to route debris and/or water to the weep hole, preferably wherein in the transportation mode, debris and standing water are prevented from entering the housing through the weep hole.

11. A portable power supply comprising:
a housing;
a first subsystem being ingress protected and positioned within the housing;
a second subsystem being ingress protected and positioned within the housing; and
a human-machine interface that is detached from the housing,
wherein the first subsystem includes a first ingress protection rating and the second subsystem includes a second ingress protection rating, and wherein the first ingress protection rating is different than the second ingress protection rating.

12. The portable power supply of claim 11, wherein the portable power supply includes a third ingress protection rating, the third ingress protection rating remaining constant when the first subsystem or the second subsystem is removed from the housing, preferably wherein the third ingress protection rating is different than the first ingress protection rating or the second ingress protection rating.

13. The portable power supply of claim 11 or 12, wherein the human-machine interface communicates with the portable power supply through a Bluetooth connection.

14. The portable power supply of claim 11, 12 or 13, wherein the human-machine interface includes an application software program executable on a smart device.

15. The portable power supply of claim 11 or 12, wherein the first subsystem is a power source, the human-machine interface configured to communicate with the power source through a wired connection.
